# EUROPEAN PATENT APPLICATION

(11) **EP 1 324 442 A2**
(43) Date of publication of application: **02.07.2003**
(21) Application number: 02017599.8
(22) Date of filing: 07.08.2002
(51) Int. Cl.: H01S 5/026

(54) **Optical semiconductor module**

(30) Priority: 20.12.2001 JP 2001387534
(71) Applicant: MITSUBISHI DENKI KABUSHIKI KAISHA, Tokyo 100-8310 (JP)
(72) Inventor: Masuda, Kenji, c/o Mitsubishi Denki Kabushiki K., Tokyo 100-8310 (JP); Sato, Makoto, c/o Mitsubishi Denki Kabushiki K., Tokyo 100-8310 (JP)
(74) Representative: Pfenning, Meinig & Partner GbR

(57) **Abstract**

An optical semiconductor module has a laser diode (LD) (1) for emitting light, a first photo-diode (PD) (2) and a second PD (3) for receiving light emitted backward from the LD (1), and a wavelength filter (5) which is disposed on a light path between the LD (1) and the first PD (2) and continuously changes the intensity according to wavelength of the light. A distance between a light receiving surface of the second PD (3) and the LD (1) is set so as to be equal to or shorter than a distance between an incident surface of the wavelength filter (5) and the LD (1).

## Description

### FIELD OF THE INVENTION

The present invention relates to improvement in detecting accuracy of a wavelength monitor section and light intensity monitor section of an optical semiconductor module to be applied to an optical transmission apparatus.

### BACKGROUND OF THE INVENTION

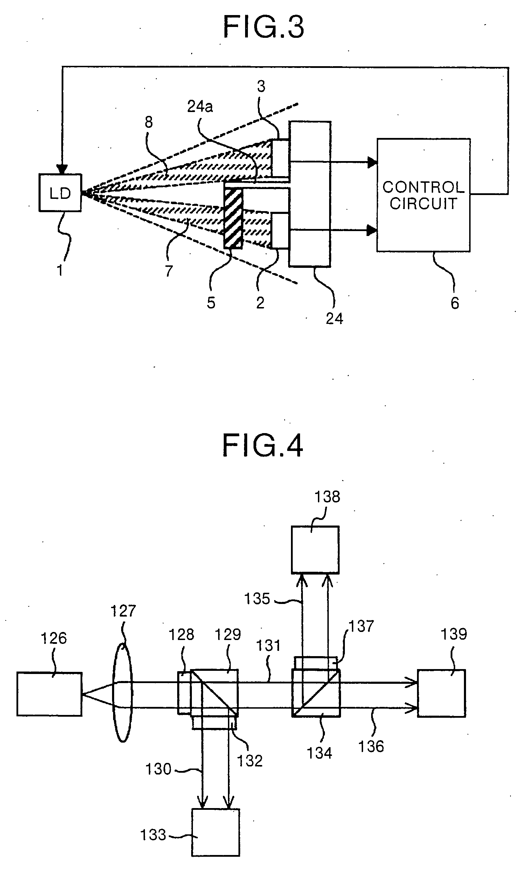

Fig. 4 shows a structure of an optical semiconductor module which is disclosed in Japanese Patent Application Laid-Open No. 10-79551 and which monitors intensity and oscillation wavelength of an output light from a semiconductor laser. Light emitted backward from an optical semiconductor laser 126 is converted into a parallel light by a lens 127 and enters a 1/4 wavelength plate 128 where a linear polarized light is converted into a circular polarized light, and the circular polarized light enters a first polarization beam splitter (PBS) 129.

In the PBS 129, the circular polarized light is separated into a first emitted light 130 and a second emitted light 131. A first emission end surface is provided with a band pass filter film 132, and the first emitted light 130 transmits through the band pass filter film 132 and is received by a first photo-diode 133. A photocurrent output of the first photo-diode 133 fluctuates according to oscillation wavelength of the semiconductor laser 126.

The second emitted light 131 enters a second PBS 134 to be separated into a third emitted light 135 and a fourth emitted light 136. A third emission end surface is provided with a band pass filter film 137, and the third emitted light 135 transmits through the band pass filter film 137 and is received by a second photo-diode 138. A photocurrent output of the second photo-diode 138 fluctuates according to the oscillation wavelength of the semiconductor laser 126.

The fourth emitted light 136 is received directly by a third photo-diode 139.

The photocurrent outputs of the first photo-diode 133 and the second photo-diode 138 are used as wavelength monitor, and the photocurrent output of the third photo-diode 139 is used as intensity monitor of the light emitted backward from the semiconductor laser. As a result, both the wavelength and the light intensity are stabilized.

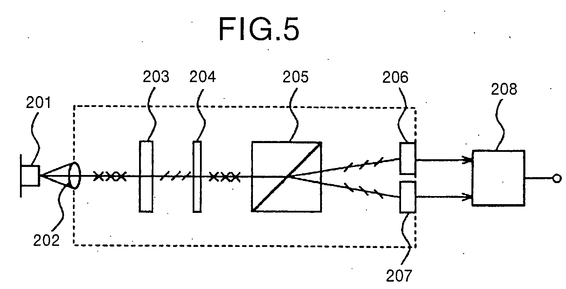

Fig. 5 shows a structure of a wavelength detecting apparatus disclosed in Japanese Utility Model Application Laid-Open No. 58-12831. Two-directional polarized components separated by a polarizer are received by a pair of photo detectors disposed on the same plane on a base (not. shown), and respective outputs of the paired photo detectors are calculated so that wavelength is detected. When the photo detectors are set on the base, the setting accuracy becomes high. However, in this structure, light intensity cannot be detected although wavelength can be detected.

Since the conventional optical semiconductor modules have the above structures, the former one has a large number of parts and thus there arises a problem that the cost of the product becomes high. Further, when three planes where photo-diodes are mounted respectively are displaced due to temperature changes and aging, there arises a problem that the intensity of the lights received by the respective photo-diodes fluctuates.

The latter one has a structure that detects only wavelength although a degree of the stability to displacement increases since the photo detectors can be mounted on the same plane to, and therefore light intensity cannot be detected.

### SUMMARY OF THE INVENTION

It is an object of the present invention to provide an optical semiconductor module capable of monitoring intensity and oscillation wavelength of an output light of a semiconductor laser accurately with a simpler structure without requiring a structure that a plurality of PBSs and a plurality of band pass filters are combined.

An optical semiconductor module according to one aspect of this invention includes an LD for emitting light, a first PD and a second PD for receiving the light emitted from the LD, and a wavelength filter disposed between the LD and the first PD to continuously change intensity of the light according to wavelength of the light. A distance between the light receiving surface of the second PD and the LD is set so as to be equal to or shorter than a distance between an incident surface of the wavelength filter and the LD.

An optical semiconductor module according to another aspect of this invention includes an LD for emitting light, a first PD and a second PD for receiving the light emitted by the LD, a wavelength filter disposed between the LD and the first PD to continuously change intensity of the light according to wavelength of the light, and a shade disposed between the first PD and the second PD and extending from a light receiving surface of the second PD at least to an incident surface of the wavelength filter.

Other objects and features of this invention will become apparent from the following description with reference to the accompanying drawings.

### BRIEF DESCRIPTION OF THE DRAWINGS

Fig. 1 is a block diagram which shows structures of a wavelength monitor section and light intensity monitor section of an optical semiconductor module according to a first embodiment of the present invention,
Fig. 2 is a characteristic example of a wavelength monitor output and light intensity monitor output,
Fig. 3 is a block diagram which shows structures of the wavelength monitor section and the light intensity monitor section of the optical semiconductor module according to a second embodiment of the present invention,
Fig. 4 is a block diagram which shows a structure of the conventional optical semiconductor module disclosed in Japanese Patent Application Laid-Open No. 10-79551, and
Fig. 5 is a block diagram which shows a structure of the conventional optical semiconductor module disclosed in Japanese Utility Model Application Laid-Open No. 58-12831.

### DETAILED DESCRIPTION

Embodiments of this invention will be explained below with reference to the accompanying drawings.

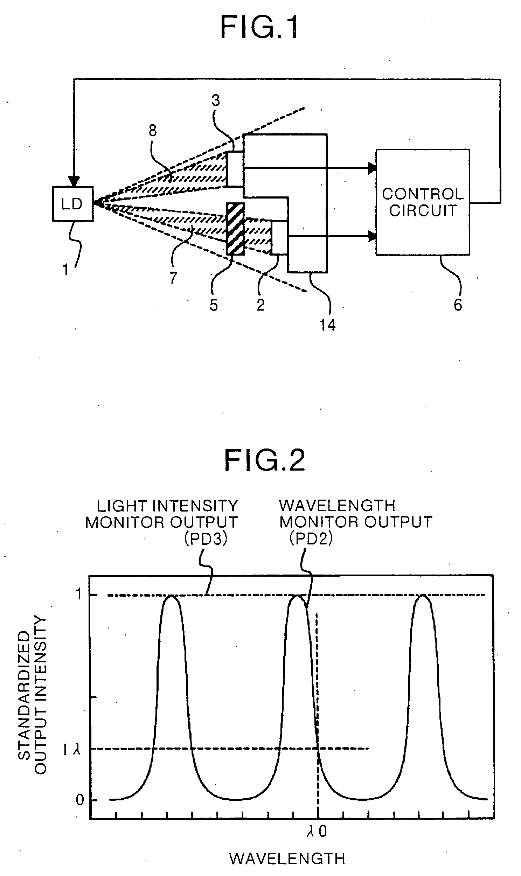

A first embodiment of this invention will be explained below. Fig. 1 is a block diagram which shows structures of a wavelength monitor section and light intensity monitor section of an optical semiconductor module according to a first embodiment of the present invention. In Fig. 1, the optical semiconductor module according to the first embodiment of the present invention is arranged so that light emitted from the rear surface of an LD 1 is received by a first PD 2 and a second PD 3. The first PD 2 is fixed to a first mounting surface of a PD carrier 14 having stepwise formed mounting surfaces, the first mounting surface being far from the LD 1, and the second PD 3 is fixed to a second mounting surface thereof which is closer to the LD 1.

A wavelength filter 5 is disposed between the LD 1 and the first PD 2, and since light 7 for entering the first PD 2 transmits through the wavelength filter 5, an output of the first PD 2 changes according to wavelength.

Light receiving surface of the second PD 3 is positioned by setting a step dimension of the carrier 14 so that a distance between the light receiving surface and an emission point of the LD 1 is equal to or shorter than that between an incident surface position of the wavelength filter 5 and the emission point. As a result, light 8 that is to enter the second PD 3 reaches the second PD 3 directly, and an output of the second PD 3 is in accordance with intensity of the light from the LD 1.

The wavelength filter to be used here may be of any system such as FP etalon, dielectric multi-layer film filter, or birefringence crystal and polarizer, as long as it has the property that transmission intensity changes continuously according to wavelength.

Fig. 2 shows an example of characteristics of a wavelength monitor output and light intensity monitor output when FP etalon, for example, is used as the wavelength filter 5. Since the first PD 2 receives a transmission light of the wavelength filter 5, it outputs a signal having a waveform shown in the figure such that the intensity continuously changes according to the wavelength as the wavelength monitor output. Since the second PD 3 directly receives an emitted light from the LD, it outputs a signal that is proportional to the intensity of the emitted light from the LD as the light intensity monitor output.

The wavelength of the emitted light from the LD is controlled by using an area where the intensity of the wavelength monitor output changes linearly and approximately to the wavelength. For example, output intensity Iλ at the time when the wavelength is λ0 as shown in Fig. 2 is output to a control circuit 6. Here, if a stray light that does not transmit through the wavelength filter 5 is coupled with the first PD 2 when the intensity of the light transmitted through the wavelength filter 5 is low, S/N of the signal has the hazard of being deteriorated. However, in the first embodiment, the PD carrier has a step, the second PD 3 is positioned just beside the wavelength filter 5 or closer to the LD 1, and a rise section exists so that the section connects the steps of the first mounting surface and the second mounting surface of the PD carrier, and it is thereby possible to prevent the stray light from being coupled with the first PD 2.

The intensity of the emitted light from the LD is controlled by outputting the output of the second PD 3 that receives light unrelated to the wavelength directly to the control circuit 6, but on the contrary to the above explanation, the light that has transmitted through the wavelength filter 5 is prevented from being a stray light to be coupled with the second PD 3 because the PD carrier has the steps and thereby the positional relationship of the PDs is set.

The control circuit 6 inputs the output of the first PD 2 as the wavelength monitor and the output of the second PD 3 as the light intensity monitor therein, controls an operating current and an operating temperature of the LD 1 so that the. wavelength monitor output and the light intensity monitor output are kept constant, and thereby stabilizes the wavelength and the light intensity.

Since the optical semiconductor module according to the first embodiment of the present invention has the above structure, the cost can be suppressed due to the simple structure, and the two PDs are fixed to the PD carrier so that the stability to displacement can be increased.

Furthermore, since the second PD 3 to be used as the light intensity monitor is arranged so as to prevent a diffraction light or a stray light of the light transmitted through the wavelength filter 5 from entering the second PD 3, there is no fear that light dependent on wavelength is added. Further, the output intensity of the second PD can be proportional to the intensity of the emitted light from the LD 1. Moreover, the steps are provided to the carrier and the rise section between the steps exists so that the fear that the stray light not transmitting through the wavelength filter 5 enters the first PD 2 can be avoided. For this reason, the output intensity of the first PD can be proportional to light continuously changing according to the wavelength that has transmitted through the wavelength filter 5.

A second embodiment of this invention will be explained below. Fig. 3 is a block diagram which shows structures of a wavelength monitor section and light intensity monitor section of the optical semiconductor module according to a second embodiment of the present invention. In Fig. 3, the optical semiconductor module according to the second embodiment of the present invention is arranged so that the first PD 2 and the second PD 3 are mounted in a row to a PD mounting surface of a PD carrier 24 and light emitted from the rear surface of the LD 1 is received by the first PD 2 and the second PD 3. The wavelength filter 5 is disposed between the LD 1 and the first PD 2, and the light 7 to enter the first PD 2 transmits through the wavelength filter 5.

A shade 24a is provided between the first PD 2 and the second PD 3 mounted on the PD mounting surface of the PD carrier 24. The shade 24a extends from the light receiving surface of the second PD 3 at least to the LD 1 side. A position of the end surface of the shade 24a closer to the LD 1 is set so that a distance between the end surface and the LD 1 is equal to or shorter than that between the incident surface position of the wavelength filter 5 and the LD 1.

As a result; the stray light that does not transmit through the wavelength filter 5 can be prevented from being coupled with the first PD 2, and the stray light that has transmitted through the wavelength filter 5 can be prevented from being coupled with the second PD 3.

The wavelength filter to be used here may be of any system such as FP etalon, dielectric multi-layer film filter, or birefringence crystal and polarizer if it has the property that transmission intensity continuously changes according to wavelength.

The shade 24a may be supported to the PD carrier 24 or may be integral with the PD carrier 24. When it is integral with the PD carrier 24, an increase in a number of parts is prevented. Further, the shade 24a may be in contact with the side surface of the wavelength filter 5.or may have a shape following a contour of the side surface of the wavelength filter 5. This enables unnecessary lights of the first PD 2 and the second PD 3 to be shaded effectively..

Since the optical semiconductor module according to the second embodiment of the present invention has the above structure, the cost can be suppressed due to the simple structure, and the two PDs are fixed to the PD carrier so that the stability to displacement can be raised. Further, since the shade is provided between the first PD 2 and the second PD 3 arranged in a row, a diffraction light and a stray light of the light transmitted through the wavelength filter 5 can be prevented from entering the second PD 3 that is used as the light intensity monitor. As result, there is no fear that light dependent on wavelength is applied, and thus the output intensity of the second PD 3 can be proportional to the intensity of the emitted light from the LD1. Moreover, since the stray light that does not transmit through the wavelength filter 5 can be avoided to enter the first PD, the output intensity of the first PD can be proportional to the light that continuously changes according to the wavelength that has transmitted through the wavelength filter 5.

As mentioned above, since the optical semiconductor module according to the present invention is constituted to allow the first PD and the second PD to receive only light that should be received by the respective PDs, accuracy of the wavelength monitor output and the light intensity monitor output as the outputs of the respective PDs can be improved. Thus, it is possible to obtain the optical semiconductor module which has less fear of the displacement due to temperature changes and aging and has both the wavelength monitor and the light intensity monitor with the simple structure.

Although the invention has been described with respect to a specific embodiment for a complete and clear disclosure, the appended claims are not to be thus limited but are to be construed as embodying all modifications and alternative constructions that may occur to one skilled in the art which fairly fall within the basic teaching herein set forth.

## Claims

1. An optical semiconductor module comprising:
a laser diode (1) for emitting light;
a first photo-diode (2) having a light receiving surface for receiving the light emitted by the laser diode (1);
a wavelength filter (5) having an incident surface, the wavelength filter (5) being disposed on a light path between the laser diode (1) and the first photo-diode (2), which continuously changes intensity of the light falling on the first photo-diode (1) according to wavelength of the light; and
a second photo-diode (3) having a light receiving surface for receiving the light emitted by the laser diode (1), the second photo-diode (3) being positioned such that a distance between the laser diode (1) and the light receiving surface of the second photo-diode (3) is equal to or shorter than a distance between the laser diode (1) and the light receiving surface of the wavelength filter (5).

2. The optical semiconductor module according to claim 1, further comprising:
a control circuit (6) for inputting output currents from the first photo-diode (2) and the second photo-diode (3) therein to generate a signal for controlling an operation of the laser diode (1).

3. The optical semiconductor module according to claim 1 or 2, further comprising:
a photo-diode carrier (14) having first and second mounting surfaces which are stepwise formed and which has the first photo-diode (2) and the second photo-diode (3) mounted thereon, respectively.

4. An optical semiconductor module comprising:
a laser diode (1) for emitting light;
a first photo-diode (2) having a light receiving surface for receiving the light emitted by the laser diode (1);
a wavelength filter (5) having an incident surface, the wavelength filter (5) being disposed on a light path between the laser diode (1) and the first photo-diode (2), which continuously changes intensity of the light falling on the first photo-diode (1) according to wavelength of the light;
a second photo-diode (3) having a light receiving surface for receiving the light emitted by the laser diode (1); and
a shade (24a) disposed between the first photo-diode (2) and the second photo-diode (3) and extending from the light receiving surface of the second photo-diode (3) at least to the incident surface of the wavelength filter (5).

5. The optical semiconductor module according to claim 4, further comprising:
a control circuit (6) for inputting output currents from the first photo-diode (2) and the second photo-diode (3) therein to generate a signal for controlling an operation of the laser diode (1).

6. The optical semiconductor module according to claim 4 or 5, further comprising:
a photo-diode carrier (24) for fixing the first photo-diode (2) and the second photo-diode (3), wherein the shade (24a) is supported to the photo-diode carrier (24).

7. The optical semiconductor module according to claim 6, wherein the shade (24a) is integral with the photo-diode carrier (24).

8. The optical semiconductor module according to claim 6 or 7, wherein the shade (24a) is in contact with a side surface of the wavelength filter (5).

9. The optical semiconductor module according to claim 8, wherein the shade (24a) has a shape following a contour of the side surface of the wavelength filter (5).
